# EUROPEAN PATENT APPLICATION

(11) **EP 4 478 846 A1**
(43) Date of publication of application: **18.12.2024**
(21) Application number: 23179011.4
(22) Date of filing: 13.06.2023
(51) Int. Cl.: H05K 5/00

(54) **LOCKING CARTRIDGE AND ASSEMBLY COMPRISING AT LEAST TWO DEVICES TO BE CONNECTED TO EACH OTHER BY MEANS OF SUCH LOCKING CARTRIDGES**

(71) Applicant: Rohde & Schwarz GmbH & Co. KG, 81671 München (DE)
(72) Inventor: Helfer, Michael, 81671 Munich (DE); Prins, Wouter, 81671 Munich (DE)
(74) Representative: Prinz & Partner mbB

(57) **Abstract**

The invention relates to a locking cartridge (10) for mounting devices (2, 4) to each other, the locking cartridge (10) having a clamping end with a displaceable clamping element (36) and a stationary abutment element (34), and an anchoring end with an anchor (22) shaped so as to be clampable between a clamping element (36) and an abutment element (34) of an adjacent locking cartridge (10). The invention further relates to an assembly comprising at least two devices (2, 4) to be connected to each other, preferably two radio devices, each of the devices (2, 4) comprising at least two of the locking cartridges (10) as defined above.

## Description

The invention relates to a locking cartridge and to an assembly comprising at least two devices to be connected to each other by means of such locking cartridges.

The devices to be connected together can be radio devices. For some applications in harsh environments, it is required that the radio devices be connected in a very reliable manner. Currently, a plurality of screws are being used which are tightened with a prescribed torque. As a result, a block of two radio devices is obtained which then can be mounted in a rack.

Handling of the block of the two radio devices however is quite burdensome, in particular because of the combined weight of the two radio devices. The screws are not accessible when the radios are placed within the rack so that they have to be connected to each other before placing them in the rack.

The object of the invention is to provide a mechanism which allows to reliably connect two devices to each other while allowing to establish the connection while the devices are already placed in a rack, and to disengage the two devices from each other also while being in a rack.

In order to solve this object, the invention provides a locking cartridge for mounting devices to each other, the locking cartridge having a clamping end with a displaceable clamping element and a stationary abutment element, and an anchoring end with an anchor shaped so as to be clampable between a clamping element and an abutment element of an adjacent locking assembly. Furthermore, an assembly is provided which comprises at least two devices to be connected to each other, preferably two radio devices, each of the devices comprising at least two of these locking cartridges.

The invention is based on the concept of using locking cartridges which have an end of a first type and an end of a second type. The first type end of one cartridge can be mechanically locked to the second type and of an adjacent cartridge. This allows connecting devices are equipped with these cartridges to each other, for example on top of each other. Thus, a mechanically strong connection between adjacent devices is possible.

Preferably, the clamping element comprises an actuating element which cooperates with an actuating mechanism, the actuating mechanism being adapted to displace the clamping element relative to the abutment element. The actuating mechanism allows an operator to connect or disconnect the two devices to each other or from each other by achieving the required movement of the clamping element relative to the abutment element.

According to an embodiment, the actuating mechanism comprises a transmission mechanism for converting an actuation input into a clamping force. The transmission mechanism is in particular provided for converting a moderate actuating input into a high clamping force so that high clamping forces can be generated without requiring high actuating forces.

The actuating mechanism can comprise a screw and a threaded bore such that a rotational movement can be transformed into a translational displacement.

The actuating mechanism can also comprise a wedge which, in a manner similar to a screw and a threaded bore, translates a comparatively low actuating forced into a higher clamping force.

According to a preferred embodiment, the wedge has a threaded bore adapted for receiving a screw portion of an actuating element. The combination of a screw mechanism and a wedge is particularly suitable for achieving high clamping forces when applying only moderate actuating forces.

According to an embodiment, the wedge cooperates with an edge of a window in a housing in which the wedge is shiftably received. The housing is the base part of the cartridge which can be mounted in the devices to be connected together. It here serves for receiving the counterforces generated when using the wedge for generating the clamping forces.

The abutment element can be a sleeve which is connected to the housing so that it can serve as a guide for the clamping element. The clamping element is preferably slidably received within the sleeve.

According to an embodiment, a spring is provided which biases the clamping element away from a clamping position. The spring ensures that the clamping element moves away from the abutment element when the actuating mechanism is operated so as to disengage the devices from each other.

According to a preferred embodiment, the clamping element has a neck portion and a head portion, the abutment element has a concave centering groove, and the anchor has a laterally open receiving channel and a convex centering projection. The centering features ensure that adjacent cartridges are connected to each other in a precisely centered position.

Preferably, each devices comprises four locking cartridges and two actuating elements accessible from a front side of the respective device. This embodiment allows connecting the devices to each other and disconnecting them from each other in a reliable manner without there being a need to have access to the lateral sides or the rear side of the radio devices.

According to an embodiment, a base plate is provided which comprises a plurality of anchor elements. The base plate serves as a foundation on which radio devices can be mounted on top of each other.

Preferably, each of the anchors has a receiving channel which is open towards the front side of the respective device. This allows removing the devices from a rack without there being a need for lateral space.

The invention will now be described with reference to an embodiment which is shown in the drawings. In the drawings,
- Figure 1 is a horizontal cross-section through two devices connected to each other with locking cartridges according to the invention,
- Figure 2 shows at an enlarged scale the combination of two of the locking cartridges from Figure 1,

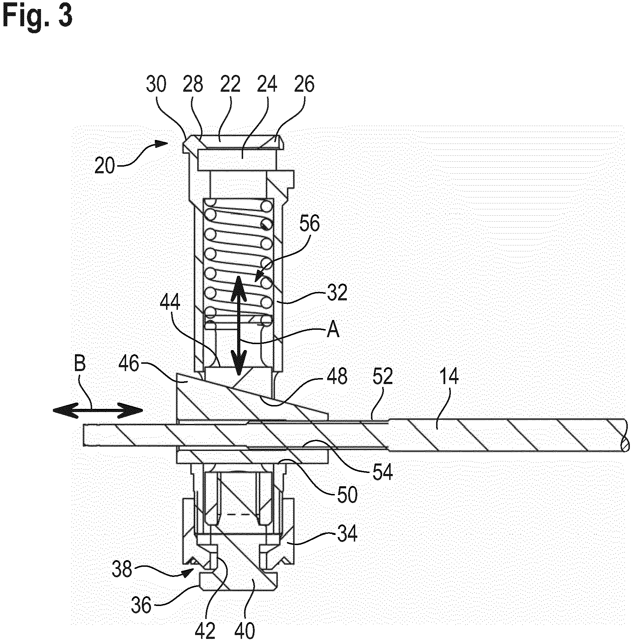

- Figure 3 shows at an even larger scale one of the cartridges shown in Figure 1,
- Figure 4 shows in a perspective view a cartridge in a receiving position, and
- Figure 5 shows the cartridge of Figure 4 in a clamping position.

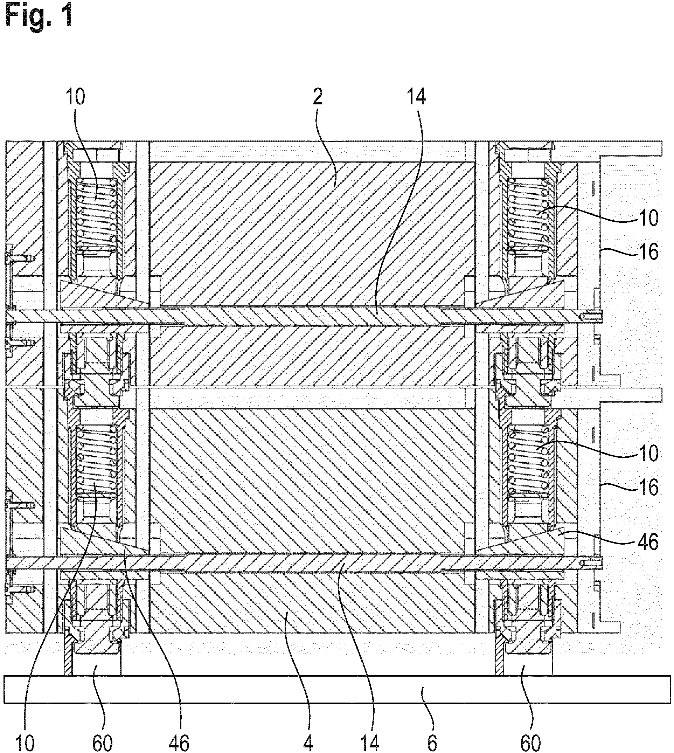

In Figure 1, a first device 2 and a second device 4 are shown, which are mounted on a base plate 6. Devices 2, 4 can be radio devices, in particular for government application such as by police forces.

Each of the devices 2, 4 is provided with a plurality of locking cartridges 10 which generally speaking serve for connecting adjacent devices 2, 4 to each other and for connecting one of the devices to base 6.

Locking cartridges 10 can be operated by means of an actuating mechanism which comprises, apart from other elements discussed below, a screw 14 which extends through the respective device 2, 4, cooperates with the locking cartridges 10 of the respective device 2, 4, and is accessible at a front end 16 of the respective device 2, 4.

"Accessible" means that a tool or a lever can be connected at the front end 16 so as to rotate screw 14.

Each of locking cartridges 10 comprises a "passive" end and an "active" end. The active end is intended to grasp and clamp the passive end of an adjacent locking cartridge 10 or a suitable element provided at base 6.

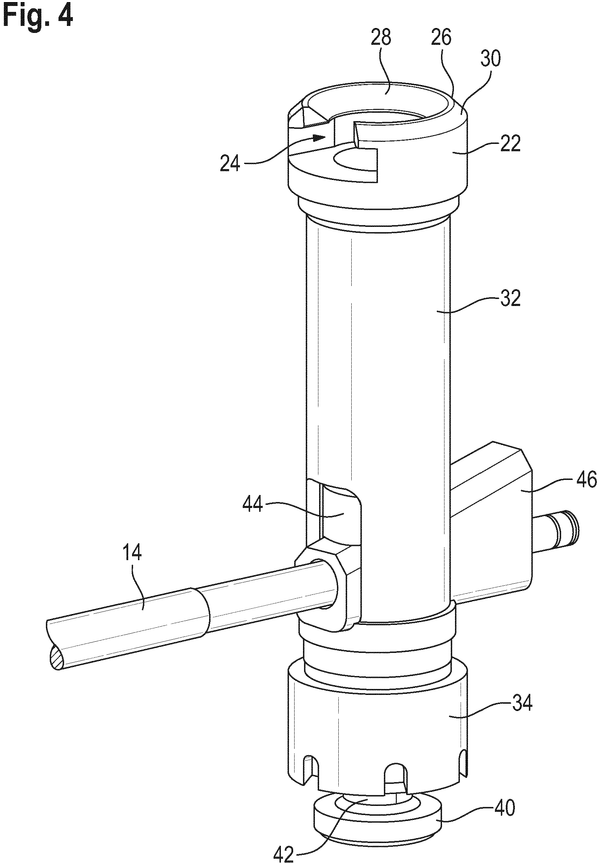

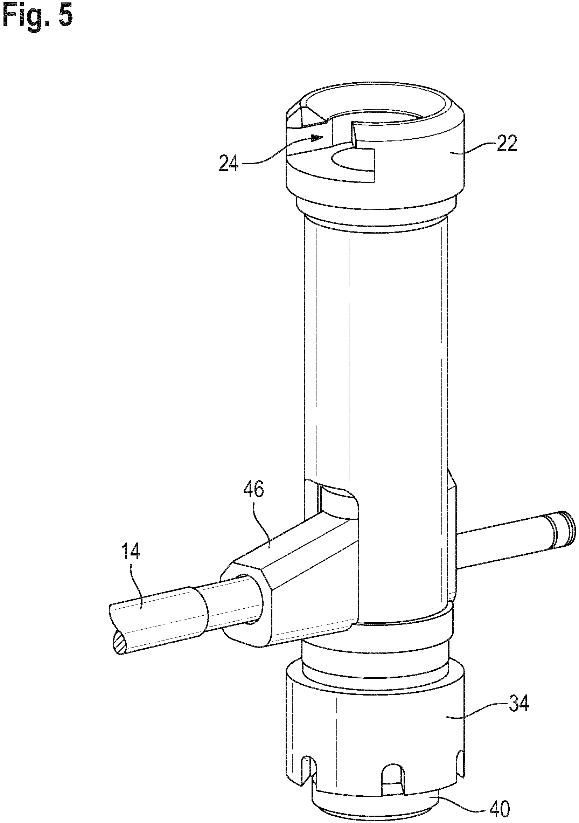

The passive end of each locking cartridge 10 is an anchoring end 20 which comprises an anchor 22. Anchor 22 has a laterally open receiving channel 24 (please see also Figures 4 and 5) which at the distal end is limited by a ring-shaped centering projection 26. Centering projection 26 is in the form of a convex centering projection which has obliquely extending inner and outer centering surfaces 28, 30.

Anchor 22 is rigidly connected to a housing 32 of locking cartridge 10. In the shown embodiment, housing 32 and anchor 22 are formed in one piece.

The active end of the locking cartridges is a clamping end adapted to clamp the anchor 22 of an adjacent locking cartridge 10. The clamping end is provided with a stationary abutment element 34 and a displaceable clamping element 36.

Stationary abutment element 34 is here generally ring-shaped and connected to housing 32. In this particular embodiment, abutment element 34 is threaded onto a thread provided at the end of housing 32 which is opposite to anchor 22.

At its distal end, abutment element 34 has a circumferentially extending centering groove 38, with the inclination of the two lateral surfaces corresponding to the inclination of surfaces 28, 30 of anchor 22.

Clamping element 36 is arranged centrally within abutment element 34 and comprises at its distal end a head portion 40 which is connected via a neck portion 42 to body 44 of clamping element 36.

The diameter of head portion 40 corresponds approximately to the inner dimension of receiving channel 24 and the diameter of neck portion 42 is slightly less than the smallest diameter of centering projection 26.

In this particular embodiment, clamping element 36 is formed in two parts, with the part comprising head portion 40 being threaded into body 44.

Clamping element 36 is displaceably received within housing 32 so that it can move in a translational manner in the direction of arrow A with respect to housing 32.

A wedge 46 is provided which is part of the actuating mechanism and which extends through a recess in clamping element 36 (more specifically: through a recess in body 44) and a window in housing 32. Wedge 46 cooperates with clamping element 36 by engaging at a surface 48 which limits the recess at the side opposite to head portion 40, and an edge 50 which limits the window at the side towards head portion 40. Wedge 46 can be driven in the direction of arrow B with respect to housing 32 of the respective cartridge 10 by means of screw 14. To this end, screw 14 is provided with an external thread 52 which cooperates with an internal thread 54 provided within wedge 46.

As can be seen in Figure 1, each of the screws 14 cooperates with two cartridges 10, with the wedges 46 of the cartridges being oriented in opposite directions. Furthermore, the direction of threads 52, 54 for the two wedges 46 cooperating with one and the same screw 14 are opposite to each other. As a result, turning screw 14 in one direction results in the wedges 46 cooperating with this screw 14 being drawn towards each other, and rotating screw 14 in the opposite direction results in the wedges 46 being spaced from each other.

In an alternative embodiment (not shown), the thread on the screw is provided only at one end while the screw is rotatably connected to the respective wedge at the other end via an abutment. The wedge not provided with a thread is therefore moved by reaction forces.

A spring 56 is arranged within housing 32, with spring 56 piercing clamping element 36 away from a clamping position in a position in which head portion 40 protrudes from abutment element 34.

In a starting position, wedge 46 only slightly engages into the recess in clamping element 36 and the window in housing 32. In this position, head portion 40 protrudes from abutment element 34 (please see the condition shown in Figure 4).

This position of head portion 40 allows to either engage into the receiving channel 24 of an anchor 22 of a device arranged underneath or at an anchoring element 60 provided at base 6.

Assuming that device 4 is to be mounted on base 6, head portion 40 is engaged into a groove of anchoring elements 60 which are connected to base 6. Subsequently, screw 14 is rotated so as to draw wedges 46 towards each other, thereby drawing head portions 40 upwardly so as to clamp the anchoring elements 60 against abutment elements 34 of cartridges 10. As a result, device 4 is rigidly connected to base 6.

In a subsequent step, device 2 is placed on device 4, with cartridges 10 being in a mounting position (please see Figure 4) in which head portion 40 protrudes from the respective cartridge. After engaging head portions 40 into receiving channel 24 of anchors 22 arranged on the opposite of device 4, screw 14 of device 2 is rotated so as to draw wedges 46 towards each other, thereby drawing head portion 40 into the clamping position (please see Figure 5) in which centering projection 26 is centered within abutment element 34 and device 2 is reliably connected to device 4.

For disengaging devices 2, 4 from each other and from base 6, screws 14 are rotated in the opposite direction such that head portions 40 are displaced from the clamping position into the mounting position in which they protrude from the respective cartridge 10. Then, head portion 40 can be disengaged from receiving channel 24 of the anchor arranged underneath.

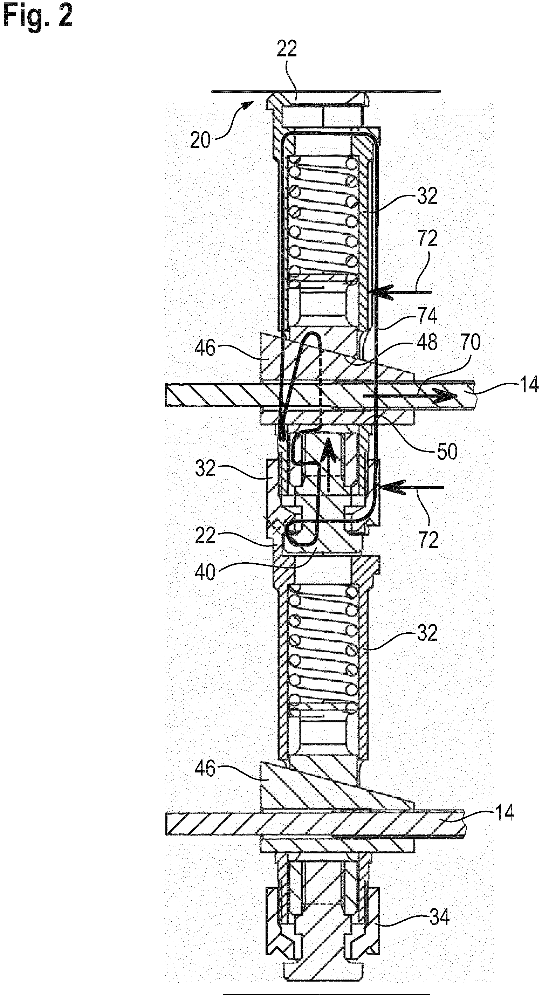

The forces occurring during actuation of the respective cartridge are shown in Figure 2.

The force exerted by screw 14 onto wedge 46 is shown with arrow 70. This force is counteracted by forces 72 resulting from housing 32 of the respective locking cartridge 10 and abutment sleeve 34 which are both received within the respective device 2, 4. The closed flow path of the forces generated by wedge 46 cooperating with clamping element 34 and clamping element 34 cooperating with anchor 22 is shown with a thin closed line 74.

One advantage of the described embodiment is that a comparatively low actuating force of screw 14 results in high clamping forces as there is a first amplification via threads 52, 54 and a second amplification via wedges 46.

It is generally possible to use an actuating mechanism which directly provides the axial displacement of head portion 40 instead of using a mechanism which extends perpendicularly with respect to the central access of the respective locking cartridges.

Another advantage of the cartridges is that they provide for a positioning and fixing at the same time so that a compact design is achieved.

It is also advantageous that two cartridges can be actuated with one screw 14.

The locking cartridges generate the axial clamping force without placing an axial load on adjacent components. It is here only the lateral force between two simultaneously actuated cartridges which has to be counteracted by the respective device.

The combination of threads 52, 54 and wedges 46 generated a locking mechanism which is self-locking because of the friction involved in the cooperating surfaces.

Due to the short force flow and the resulting high rigidity, the required pretensioning force is very low.

Any manufacturing tolerances are simply compensated for by the preload. Only a few dimensions have to be manufactured with a small tolerance field, which enables manufacturing costs to be optimized.

The contacting cone surfaces of the cartridge and cone nut can be produced by turning, which simply allows high precision at low cost.

The fit of the cartridge can be produced by machining from a clamping direction on the processing machine. This results in inherent high possible accuracy for all three directions of the Cartesian coordinate system.

Unlocking can be accomplished by spring force assistance, which favors easy separation of the two objects.

Depending on the nature of the object, parts of the locking mechanism can be integrated to reduce the variety of parts.

If this principle is designed as a cartridge or insert part, a damaged part, if any, can be replaced.

Recycling is simplified by the use of a harmonized alloy and easily separable connections.

## Claims

1. A locking cartridge (10) for mounting devices (2, 4) to each other, the locking cartridge (10) having a clamping end with a displaceable clamping element (36) and a stationary abutment element (34), and an anchoring end with an anchor (22) shaped so as to be clampable between a clamping element (36) and an abutment element (34) of an adjacent locking cartridge (10).

2. The locking cartridge (10) of claim 1 wherein the clamping element (36) comprises an actuating element (46) which cooperates with an actuating mechanism (14), the actuating mechanism being adapted to displace the clamping element (36) relative to the abutment element (34).

3. The locking cartridge (10) of claim 2 wherein the actuating mechanism comprises a transmission mechanism (46, 48, 50; 52, 54) for converting an actuating input into a clamping force.

4. The locking cartridge (10) of claim 3 wherein the actuating mechanism comprises a screw (14) and a threaded bore (54).

5. The locking cartridge (10) of claim 3 or claim 4 wherein the actuating mechanism comprises a wedge (46).

6. The locking cartridge (10) of claim 5 wherein the wedge (46) has a threaded bore (54) adapted for receiving a screw portion (52) of an actuating element (14).

7. The locking cartridge (10) of claim 5 or claim 6 wherein the wedge (46) cooperates with an edge (50) of a window in a housing (32) in which the wedge (46) is shiftably received.

8. The locking cartridge (10) of claim 7 wherein the abutment element (34) is a sleeve which is connected to the housing (32).

9. The locking cartridge (10) of claim 8 wherein the clamping element (36) is slidably received within the sleeve (34).

10. The locking cartridge (10) of any one of the preceding claims wherein a spring (56) is provided which biases the clamping element (36) away from a clamping position.

11. The locking cartridge (10) of any one of the preceding claims wherein the clamping element (36 has a neck portion (42) and a head portion (40), the abutment element (34) has a concave centering groove (38), and the anchor (22) has a laterally open receiving channel (24) and a convex centering projection (26).

12. An assembly comprising at least two devices (2, 4) to be connected to each other, preferably two radio devices, each of the devices (2, 4) comprising at least one of the locking cartridges (10) as defined in one of the preceding claims.

13. The assembly of claim 12 wherein each device (2, 4) comprises four locking cartridges (10) and two actuating elements (14) accessible from a front side of the respective device (2, 4).

14. The assembly of claim 12 or claim 13 wherein a base plate (6) is provided which comprises a plurality of anchor elements (60).

15. The assembly of any one of claims 12 to 14 wherein each of the anchors (22) has a receiving channel (24) which is open towards the front side of the respective device (2, 4).
